(19) Europäisches Patentamt
European Patent Office
Office européen des brevets

(11) **EP 0 876 022 B1**

(12) **EUROPÄISCHE PATENTSCHRIFT**

(45) Veröffentlichungstag und Bekanntmachung des Hinweises auf die Patenterteilung:
**15.01.2003 Patentblatt 2003/03**

(51) Int Cl.⁷: $H04L\ 1/00$, $H04L\ 1/20$

(21) Anmeldenummer: **98440052.3**

(22) Anmeldetag: **18.03.1998**

(54) **Verfahren und Vorrichtung zur Fehlerverdeckung in digitalen Übertragungssystemen**

Method and apparatus for error concealment in digital transmission systems

Procédé et dispositif pour masquage d'erreurs dans des systèmes digitaux de transmission

(84) Benannte Vertragsstaaten:
**DE ES FR GB IT**

(30) Priorität: **17.04.1997 DE 19716147**

(43) Veröffentlichungstag der Anmeldung:
**04.11.1998 Patentblatt 1998/45**

(73) Patentinhaber: **ALCATEL**
**75088 Paris (FR)**

(72) Erfinder:
• **Vary, Peter, Dr.**
**52074 Aachen (DE)**
• **Fingscheidt, Tim**
**52072 Aachen (DE)**

(74) Vertreter: **Kugler, Hermann, Dipl.-Phys. et al**
**Alcatel**
**Intellectual Property Department, Stuttgart**
**70430 Stuttgart (DE)**

(56) Entgegenhaltungen:
**US-A- 5 502 713**

• **T. FINGSCHEIDT UND P. VARY: "Error Concealment by Softbit Speech Decoding" ITG-FACHTAGUNG SPRACHKOMMUNIKATION, 17. - 18. September 1996, Seiten 7-10, XP002075522 Frankfurt am Main**
• **C.G. GERLACH: "A Probabilistic Framework for Optimum Speech Extrapolation in Digital Mobile Radio" ICASSP-93; 1993 INTERNATIONAL CONFERENCE ON ACOUSTICS, SPEECH AND SIGNAL PROCESSING, Bd. 2, 27. - 30. April 1993, Seiten 419-422, XP000427815 Minneapolis, USA**

## Beschreibung

### Anwendungsgebiet

Die Erfindung betrifft ein Verfahren sowie eine Vorrichtung entsprechend dem Oberbegriff des Anspruchs I.

### Stand der Technik I

Um Übertragungsfehler in digitalen Übertragungssystemen für Audio-Sprach- oder Bildsignale empfangsseitig verdecken zu können, werden derzeit Rahmenwiederholungsverfahren eingesetzt, die im Falle unkorrigierter Fehler ggfs. den letzten korrekt empfangenen Bit-Rahmen (oder Teile davon) wiederholen (z.B. Recommendation GSM 06.11, "Substitution and Muting of Lost Frames for Full Rate Speech Traffic Channels", ETSI/TC SMG, Februar 1992). Diese Rahmenwiederholung wird durch eine binäre Rahmenzuverlässigkeitsinformation initiiert, die man z.B. aus der Empfangsfeldstärke, aus Metrikdifferenzen eines Kanaldecoders, oder auch aus der Auswertung eines Fehlererkennungsverfahrens gewinnen kann. Weitergehende Verfahren (z.B. T. Lagerqvist, T.B. Minde, P. Mustel und H. Nilsson, "Soft Error Concealment in a TDMA Radio System", U.S.-Patent #5,502,713, Dezember 1993) sind imstande, eine gewichtete Kombination von Quellcodec-Parametern des aktuellen Rahmens und vorhergehender durchzuführen, wobei die Wichtung die Rahmen-Fehlerwahrscheinlichkeiten bzw. Parameter-Fehlerwahrscheinlichkeiten widerspiegelt.

### Nachteile des Standes der Technik I

Nachteile dieser Verfahren bestehen in der relativ schnellen Abnahme der decodierten Audio-/Sprach-/Bildqualität, wenn der Übertragungskanal zunehmend unzuverlässiger wird. Dies macht sich in Abhängigkeit vom eingesetzten Quellcodierverfahren durch z.T. extrem störende Klick- oder Modulationseffekte bemerkbar, die oftmals durch zusätzlich angewandte Stummschaltmechanismen unterdrückt werden müssen. Auch hierunter leidet die Qualität der rekonstruierten Signale offensichtlich.

Desweiteren wird das statistische Verhalten der Quellcodec-Parameter durch die gewichtete Summation aus aktuellem und vorangegangenen Rahmen nur sehr vage modelliert, was zu entsprechend ungenauen Schätzergebnissen führt. Zudem ist die Verwendung allein einer Fehlerwahrscheinlichkeit zu einem empfangenen Quellcodec-Parameterwert (bzw. der ihn repräsentierenden Bitkombination) suboptimal im Vergleich zu dem Fall, wo empfangsseitig zu jedem möglichen gesendeten Parameterwert je eine Wahrscheinlichkeit bekannt ist.

### Stand der Technik II

Die Fehlerverdeckung kann verbessert werden, wenn wie aus "Error Concealment by Softbit Speech Decoding", Proceedings ITG-Fachtagung "Sprachkommunikation", Frankfurt a.M., September 1996, bekannt, die quantisierten Quellcodec-Parameter als wertediskrete Markoff-Prozesse $N$-ter Ordnung modelliert werden und zu jedem Zeitpunkt eine Wahrscheinlichkeitsverteilung aller möglichen gesendeten Parameterwerte bekannt ist. Unter Verwendung parameterindividueller Schätzverfahren wird bei dieser Technik jeder Quellcodec-Parameter geschätzt.

### Nachteile des Standes der Technik II

Dieses Verfahren weist jedoch in Abhängigkeit der Bitanzahl $M$ des zu schätzenden Quellcodec-Parameters in Verbund mit der Modellordnung $N$ einen exponentiell steigenden Speicherbedarf und eine exponentiell steigende numerische Komplexität auf. Aus diesem Grunde konnten Quellcodec-Parameter mit hoher Bitanzahl $M$ bislang nur mit niedrigen Modellordnungen $N$ geschätzt werden.

### Aufgabe der Erfindung

Die Aufgabe der Erfindung ist es, ein Verfahren und eine Vorrichtung zur Fehlerverdeckung in digitalen Übertragungssystemen zu schaffen, die eine weitreichende Qualitätsverbesserung der Sprach- bzw. Audio- oder Bildsignale erzielt und dafür lediglich einen geringen Aufwand an Speicherbedarf und numerischer Komplexität erfordert.

### Lösung der Aufgabe

Diese Aufgabe wird durch ein Verfahren mit den Merkmalen des Anspruchs I und durch eine Vorrichtung mit den Merkmalen des Anspruchs 16 gelöst.

**Vorteile der Erfindung**

Das erfindungsgemäße Verfahren ist z.B. für digitale Mobilfunkempfänger, für digitale Schnurlostelefone, für digitale Rundfunkempfänger, oder auch für die ATM-Übertragung von Sprach- und Audiosignalen geeignet. Es kann gleichermaßen in der Bild-/Videoübertragung zur Anwendung kommen. Prinzipiell kann es überall dort eingesetzt werden, wo zu jedem empfangenen quell-codierten Bit oder auch Bitgruppen eine Zuverlässigkeitsinformation zur Verfügung steht. Der in dem Verfahren vorgesehene Prädiktor ermöglicht die Berechnung einer Wahrscheinlichkeitsverteilung zu jedem möglicherweise gesendeten Quellcodec-Parameter, wobei ein deutlich verringerter Speicheraufwand und eine deutlich verringerte numerische Komplexität gegenüber dem Stand der Technik zu verzeichnen sind. Die Ordnung des Prädiktors kann mit marginalem Einfluß auf Speicheraufwand und numerische Komplexität der Gesamtvorrichtung so gewählt werden, daß möglichst viel Restkorrelation des zu schätzenden Parameters zur Fehlerverdeckung ausgenutzt wird. Das wiederum wirkt sich auf eine deutlich verbesserte Verdeckung der Übertragungsfehler aus.
Das erfindungsgemäße Verfahren ermöglicht überdies eine effiziente Schätzung auch nicht-stationärer Quellcodec-Parameter.

**Beschreibung von Ausführungsbeispielen**

Ausführungsbeispiele der Erfindung sind in der Zeichnung anhand mehrerer Figuren dargestellt und in der nachfolgenden Beschreibung näher erläutert. Es zeigt:

1. ein Blockschaltbild eines erfindungsgemäßen Verfahrens in einfacher Ausführung,

2. ein Blockschaltbild eines erfindungsgemäßen Verfahrens zur Schätzung von Parametern mit nicht-stationärem Prädiktionsfehlersignal.

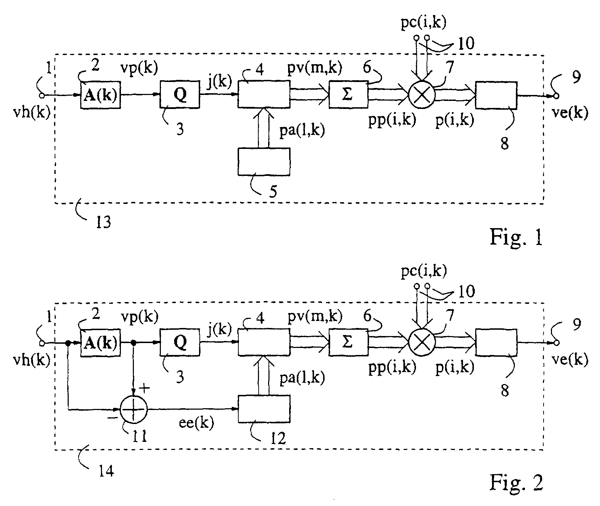

Die Ausführungsbeispiele gemäß Fig. 1, 2 sind zwar als Blockschaltbild dargestellt. Dieses bedeutet jedoch nicht, daß das erfindungsgemäße Verfahren auf eine Realisierung mit Hilfe von einzelnen den Blöcken entsprechenden Schaltungen begrenzt ist. Das erfindungsgemäße Verfahren ist vielmehr in besonders vorteilhafter Weise mit Hilfe von hochintegrierten Schaltungen realisierbar. Dabei können digitale Signalprozessoren eingesetzt werden, welche bei geeigneter Programmierung die in den Blockschaltbildern dargestellten Verarbeitungsschritte durchführen.
Die folgenden Ausführungsbeispiele zeigen, auf welchem Wege ein Parameterwert $v(k)$ geschätzt werden kann. Dabei bezeichnet k den zeitlichen Index der Abtastwerte, d.h. für rahmenweise übertragene Parameter ist es ein Rahmenzähler, für subrahmenweise übertragene Parameter ist es ein Subrahmenzähler, usw.
Ist im folgenden von einem "Parameter" die Rede, so kann es sich z.B. um einen übertragenen Quellcodec-Parameter handeln, es kann sich jedoch auch um eine durch eine beliebige umkehrbare Funktion $v'(k) = f(v(k),...)$ aus einem Parameter hervorgegangene Größe handeln. Der gewonnene Schätzwert $ve'(k)$ wäre mit der Umkehrfunktion $ve(k) = f^{-1}(ve'(k),...)$ in den gesuchten Schätzwert des Parameters zurückzuwandeln. Die Ausführungsbeispiele beschränken sich auf die Schätzung eines skalaren reellen Parameters, wenngleich die Anordnung einfach parallelisiert werden kann und damit auch einen vektoriellen Parameter zu schätzen imstande ist.
In dem Ausführungsbeispiel gemäß Fig. 1 wird zunächst eine Prädiktion $vp(k)$ des zu schätzenden Parameterwertes $v(k)$ durchgeführt. Zu diesem Zweck wird das Eingangssignal $vh(k)$ über den Eingang 1 in die Fehlerverdeckungsvorrichtung 13 eingespeist. Das Signal $vh(k)$ bildet dann den Eingang des Prädiktors 2. Es ist sinnvoll, $vh(k) = ve(k-1)$ zu wählen, d.h. daß das Eingangssignal des Prädiktors gleich dem Schätzsignal $ve(k)$ selbst ist (man beachte die minimale Verzögerung des Prädiktors 2 von einem Abtasttakt!). Auch andere Signale sind als Grundlage der Prädiktion denkbar: z.B. der ohne jeden Fehlerverdeckungsmechanismus decodierte Parameter. Der Prädiktor 2 kann z. B. ein Transversalfilter der Ordnung $N$ mit der Stoßantwort $A(k) = \{0,a_1,a_2,...,a_N,0,...\}$ sein.
Die Koeffizienten $A(k)$ des Prädiktors 2 repräsentieren die zeitlichen Korrelationen des zu schätzenden Parameters. Die Prädiktionsordnung $N$ sollte die Ausdehnung zeitlicher Korrelationen im betrachteten Parameter weitestgehend umfassen. Die Prädiktionskoeffizienten können fest in einem Speicherbaustein gespeichert sein, oder aber über eine empfangsseitige LPC-Analyse oder einen empfangsseitigen LMS-Algorithmus adaptiv nachgestellt werden.
Das Prädiktionssignal $vp(k)$ wird einem linearen, gleichmäßigen Quantisierer 3 zugeführt. Hat der Parameter $2^M$ Quantisierungsniveaus (Quantisierung mit $M$ bit), so habe der Quantisierer 3 eine Anzahl von $L \cdot 2^M$ Quantisierungsniveaus. Der Integerwert L bezeichnet im folgenden eine "Auflösung" und ist im Bereich 1...16 (evtl. auch größer) sinnvoll zu wählen. Die Quantisierungsstufenbreite dieses linearen, gleichmäßigen Quantisierers (günstig ist eine midtreat-Charakteristik) ist derart zu wählen, daß der Bereich optimaler Aussteuerung derselbe ist, wie der des Parameter-Quantisierers im Quellcodierverfahren.
Der Quantisiererausgang $j(k)$ liegt im Bereich $0...L \cdot 2^M - 1$ und stellt den Quantisierungstabellenindex dar.
Im folgenden soll unter einem "vektoriellen" Signal und seiner Verarbeitung wahlweise eine echte Parallelverarbeitung gleichzeitig anliegender, gleichartiger Signale verstanden werden, oder aber eine serielle Verarbeitung dieser gleichartigen Signale unter Benutzung lediglich einer skalar arbeitenden Vorrichtung.

Der "Verschiebeblock" 4 verschiebt nun ein gegebenes vektorielles Signal $pa(l,k)$ um eine Anzahl von $L \cdot 2^M$-$j(k)$ Vektordimensionen, d.h.

$$pv(m,k) = pa(m = l - [L \cdot 2^M - j(k)], k). \qquad (1)$$

Dabei bezeichnet $l$ einen Zähler über alle Vektordimensionen in $pa(l,k)$ mit $0 \le l \le L \cdot 2^{M+1}$-1, und $m$ ist ein verschobener Zähler über den eingeschränkten Bereich $0 \le m \le L \cdot 2^M$ - 1.

Diese Verschiebeoperation kann auch durch Kopieren der Signalwerte $pa(l,k)$ mit $= L \cdot 2^M$-$j(k)$,...,$L \cdot 2^{M+1}$-1-$j(k)$ in $pv(m,k)$ mit $m = 0$,...,$L \cdot 2^M$ - 1 oder einfach durch eine geeignete Adressierung der Vektordimensionen des Signals $pa(l,k)$ ausgeführt werden. Die Signalwerte des verschobenen Signals $pv(m,k)$ können als Verteilungsfunktion des a priori bestimmten Parameterschätzwertes $ve(k)$ interpretiert werden, wobei der Parameter als mit dem Quantisierer 3 quantisiert angenommen wird. Während die lineare Prädiktion aufgrund vergangener, empfangsseitig bekannter Parameterwerte allein einen Prädiktionswert liefert, ist nun eine A-priori-Verteilung bekannt, die jedoch noch nicht den aktuell empfangenen Parameterwert und dessen Zuverlässigkeit berücksichtigt.

Die $L \cdot 2^{M+1}$ Werte des vektoriellen Signals $pa(l,k)$ zum Zeittakt k repräsentieren das Histogramm des Prädiktionsfehlersignals $e(k) = vp(k)$-$v(k)$, wenn das Eingangssignal $vh(k)$ des Prädiktors 2 gleich dem fehlerfreien Parameter $v(k)$ wäre, und das Prädiktionsfehlersignal $e(k)$ mit einem linearen, gleichmäßigen Quantisierer ähnlich 3, bei gleicher Stufenbreite jedoch mit $L \cdot 2^{M+1}$ Quantisierungsniveaus, quantisiert würde.

In der einfachsten Ausführung gemäß Fig. 1 werden die $L \cdot 2^{M+1}$ Signalwerte von $pa(l,k)$ einmalig mit Hilfe einer großen Datenbasis des betrachteten, ungestörten Parameters $v(k)$ erzeugt und im Empfänger fest in einem Speicherbaustein 5 zur Verfügung gehalten. In diesem Fall wird der Prädiktionsfehler als stationärer Prozeß mit fester Verteilungsfunktion und Varianz modelliert.

Das vektorielle Signal $pv(m,k)$ der Vektordimension $L \cdot 2^M$ wird nun mit dem Summierer 6 abschnittweise aufsummiert, so daß sich ein vektorielles Signal $pp(i,k)$ mit $0 \le i \le 2^M$ - 1 ergibt:

$$pp(i,k) = \sum_{m=ui}^{oi} pv(m,k) \qquad (2)$$

Dabei bezeichnen $ui$ bzw. $oi$ den untersten bzw. den obersten Quantisierungstabellenindex des Quantisierers 3, der - ein gleichverteiltes Eingangssignal vorausgesetzt - (sicher oder am wahrscheinlichsten) dem $i$-ten Index des $2^M$-stufigen Quantisierers des Quellencodierers zugeordnet werden kann. Diese Operation macht den Bezug der als A-priori-Verteilungsfunktion interpretierbaren Signalwerte $pv(m,k)$ auf den evtl. höher aufgelösten linearen, gleichmäßigen Quantisierer 3 rückgängig und liefert über $pp(i,k)$ Signalwerte, die als (noch unnormierte) A-priori-Verteilungsfunktion des Parameters mit Bezug auf den Quantisierer des Quellencodierers interpretiert werden kann.

Das vektorielle Signal $pp(i,k)$ wird nun einem vektoriellen Multiplizierer 7 zugeführt. Nach Multiplikation mit dem vektoriellen Signal $pc(i,k)$ mittels

$$p(i,k) = pp(i,k) \cdot pc(i,k) \qquad (3)$$

ergibt sich über die Signalwerte des vektoriellen Signals $p(i,k)$, $i = 0,1,...,2^M$-1 eine (noch unnormierte) Wahrscheinlichkeit für jeden sendeseitigen Quantisierungstabellenindex $i$. Durch die Zuführung des vektoriellen Signals $pc(i,k)$ über die $2^M$ Klemmen 10 und die beschriebene Multiplikation sind jetzt auch der tatsächlich empfangene Parameterwert im Zeittakt $k$ sowie dessen Zuverlässigkeit berücksichtigt. Die Generierung des rein übertragungskanalabhängigen Signals $pc(i,k)$ kann z.B. wie in "Error Concealment by Softbit Speech Decoding", Proceedings ITG-Fachtagung "Sprachkommunikation", Frankfurt a.M., September 1996, beschrieben, durchgeführt werden.

In eben genannter Literaturstelle ist weiterhin gezeigt, wie nun mit den $2^M$ Werten von $p(i,k)$ zu jedem Abstastzeitpunkt $k$ beliebige Schätzverfahren 8 eingesetzt werden können, um einen Schätzwert $ve(k)$ des Parameters $v(k)$ zu erlangen. Ein Maximum-a-posteriori-Schätzer (MAP) z.B. wählt denjenigen Parameter aus der Lookup-Tabelle, der mit demjenigen $i$ adressiert wird, zu dem $p(i,k)$ für alle $i$ den maximalen Signalwert annimmt. Er liefert vielfach gute Fehlerverdeckungsergebnisse, oftmals ist jedoch ein MS-Schätzer von Vorteil, der den mittleren quadratischen Fehler $(ve(k)$-$v(k))^2$ minimiert. Bei Verwendung des letzteren müssen die Werte des vektoriellen Signals $p(i,k)$ in jedem Abtasttakt $k$ in der Summe auf 1 normiert werden, oder - was effizienter zu realisieren geht - der entsprechende Normierungsfaktor wird einmalig auf den Parameterschätzwert $ve(k)$ angewandt.

Mit Hinblick auf T. Lagerqvist, T.B. Minde, P. Mustel und H. Nilsson, "Soft Error Concealment in a TDMA Radio System", U.S.-Patent #5,502,713, Dezember 1993, muß betont werden, daß bei dem hier dargestellten Verfahren nicht nur 1 Qualitätswert pro Empfangsparameter verwendet wird, sondern $2^M$, d.h. zu jedem möglichen gesendeten Parameterwert liegt eine Empfangswahrscheinlichkeit vor. Desweiteren trifft das Verfahren prinzipiell keine Auswahl über den aktuell empfangenen Parameter, sondern arbeitet bis zur letztlichen Parameterschätzung 8 durchweg mit Signalen, die als Wahrscheinlichkeitsverteilung interpretiert werden können.

In Fig. 2 ist ein Ausführungsbeispiel zur Schätzung von Parametern gezeigt, deren Prädiktionsfehlersignal $e$ $(k)$ nur schwer als stationär modellierbar ist. In diesem Fall empfiehlt sich für den Prädiktor 2 eine empfangsseitige Adaption der Koeffizienten, wie oben bereits als Option erwähnt. Darüber hinaus wird der Speicherbaustein 5 aus Fig. 1 durch einen "A-priori-Rechner" 12 ersetzt, der auf verschiedene Weise arbeiten kann:

- Er kann z.B. in Abhängigkeit vorgegebener Kriterien zwischen verschiedenen Signalen $pa(l,k)$, die ihrerseits in einem oder mehreren Speicherbausteinen abgelegt sind, wählen.

- er kann z.B. in Abhängigkeit vorgegebener Kriterien bei einem oder mehreren abgespeicherten vektoriellen Signalen höherer Vektordimension eine Offset-Adressierung (d.h. eine geeignete Unterabtastung der Vektordimensionen) vornehmen, um $pa(l,k)$ zu erzeugen,

- er kann z.B. in Abhängigkeit vorgegebener Kriterien verschiedene Signale $pa(l,k)$ berechnen.

Als Entscheidungskriterium kann zum Beispiel eine Varianzschätzung des Prädiktionsfehlersignals $e(k)$ geeignet sein. Da der fehlerfreie Parameter $v(k)$ zur Berechnung $e(k)$ empfangsseitig nicht verfügbar ist, wird z.B. mittels eines Subtrahierers 11 eine Schätzung

$$ee(k) = vp(k) - vh(k) \qquad (4)$$

des Prädiktionsfehlersignals $e(k)$ vorgenommen. Der A-priori-Rechner 12 kann dann mit Hilfe bekannter Verfahren die Varianz des Signals $ee(k)$ in geeigneten Intervallen schätzen, um dem Verschiebeblock 4 dasjenige Signal $pa(l,k)$ zur Verfügung stellen zu können, das die momentane Signalcharakteristik von $ee(k)$ am besten repräsentiert.

Denkbar ist es auch, das Signal $pa(l,k)$ ganz oder teilweise (z.B. über eine Wichtung mit entsprechenden Signalen aus Speicherbausteinen) aus einem decoderseitig erstellten Histogramm des quantisierten Differenzsignals $Q(ee(k))$ zu erzeugen. Dabei ist ein Quantisierer gleicher Quantisierungsstufenbreite wie Quantisierer 3, jedoch mit $L \cdot 2^{M+1}$ Quantisierungsniveaus vorausgesetzt.

## Patentansprüche

1. Verfahren zur Fehlerverdeckung und Verbesserung der Signalqualität in digitalen Übertragungssystemen zur Übertragung von Sprach-, Audio-, Bildund/oder Videosignalen, in denen empfangsseitig eine Verteilungsfunktion zur Schätzung übertragener Parameter bestimmt wird,
**dadurch gekennzeichnet, daß** eine gegebene, A-priori-Verteilungsfunktion, die direkt oder indirekt das Histogramm eines Prädiktionsfehlersignals (e(k)) repräsentiert, um den quantisierten (3) Ausgangssignalwert eines Prädiktors (2), der eine Prädiktion des zu schätzenden Parameterwertes (v(k)) durchführt, verschoben (4) und abschnittsweise zu einer neuen Verteilungsfunktion (pp(i,k)) aufintegriert (6) wird, diese neue Verteilungsfunktion (pp(i,k)) mit einer die Empfangsqualität berücksichtigenden Verteilungsfunktion (pc(i,k)) multipliziert wird, mit dem Ergebnis einer A-posteriori-Verteilung (p(i,k)), die in konventionellen Schätzverfahren zur letztendlichen Parameterschätzung verwendet wird, dass mittels lines
Verschiebeblocks (4) ein gegebenes vektorielles Signal $pa(l,k)$ um eine Anzahl von $L \cdot 2^M$-$j(k)$ Vektordimensionen, d.h.

$$pv(m,k) = pa(m = l - [L \cdot 2^M - j(k)],\ k),$$

verschoben wird;
dabei bezeichnet $l$ einen Zähler über alle Vektordimensionen in $pa(l,k)$ mit $0 \le l \le L \cdot 2^{M+1}$-1, und $m$ ist ein verschobener Zähler über den eingeschränkten Bereich $0 \le m \le L \cdot 2^M$-1, und dass
das vektorielle Signal $pv(m,k)$ der Vektordimension $L \cdot 2^M$ mittels lines Summiereis (6) abschnittweise aufsummiert wird, so daß sich ein vektorielles Signal $pp(i,k)$ mit $0 \le i \le 2^M - 1$ ergibt:

$$pp(i,k) = \sum_{m=ui}^{oi} pv(m,k)_j$$

dabei bezeichnen *ui* bzw *oi* den untersten bzw. den obersten Quantisierungstabellenindex eines Quantisierers (3).

2. Verfahren zur Fehlerverdeckung nach Anspruch 1, **dadurch gekennzeichnet, daß** frühere, geschätzte Parameter das Eingangssignal des Prädiktors bilden.

3. Verfahren zur Fehlerverdeckung nach Anspruch 1 oder 2, **dadurch gekennzeichnet, daß** die empfangenen Parameter oder eine Mischgröße aus früheren, geschätzten Parametern und den empfangenen Parametern das Eingangssignal des Prädiktors bilden.

4. Verfahren zur Fehlerverdeckung nach einem der vorherigen Ansprüche, **dadurch gekennzeichnet, daß** der Prädiktor mit einem oder mehreren festen Koeffizientensätzen arbeitet.

5. Verfahren zur Fehlerverdeckung nach einem der Ansprüche 1 bis 3, **dadurch gekennzeichnet, daß** der Prädiktor mit adaptiv nachgeführten Koeffizientensätzen arbeitet.

6. Verfahren nach Anspruch 1, **dadurch gekennzeichnet, daß** es sich anstelle um einen Parameter um eine durch eine beliebige umkehrbare Funktion (v'(k)) aus einem Parameter hervorgegangene Größe handelt.

7. Verfahren zur Fehlerverdeckung nach einem der vorherigen Ansprüche, **dadurch gekennzeichnet, daß** die Verteilungsfunktionen diskretisiert vorliegen und die Integration in eine Summation übergeht.

8. Verfahren zur Fehlerverdeckung nach einem der vorherigen Ansprüche, **dadurch gekennzeichnet, daß** eine zu verschiebende Verteilungsfunktion im Empfänger gespeichert vorliegt.

9. Verfahren zur Fehlerverdeckung nach einem der Ansprüche 1 bis 7, **dadurch gekennzeichnet, daß** mehrere Verteilungsfunktionen im Empfänger gespeichert vorliegen und diejenige zu verschiebende nach geeigneten Kriterien ausgewählt wird.

10. Verfahren zur Fehlerverdeckung nach einem der Ansprüche 1 bis 7, **dadurch gekennzeichnet, daß** eine oder mehrere Verteilungsfunktionen im Empfänger gespeichert vorliegen, eine nach geeigneten Kriterien ausgewählt wird und die zu verschiebende Verteilungsfunktion durch Auswahl geeigneter Signalwerte der ausgewählten Verteilungsfunktion gebildet wird.

11. Verfahren zur Fehlerverdeckung nach einem der vorherigen Ansprüche, **dadurch gekennzeichnet, daß** die zu verschiebende Verteilungsfunktion ganz oder teilweise berechnet wird.

12. Verfahren zur Fehlerverdeckung nach einem der vorherigen Ansprüche, **dadurch gekennzeichnet, daß** die Verschiebung der Verteilungsfunktion durch geeignete Adressierung realisiert wird.

13. Verfahren zur Fehlerverdeckung nach einem der vorherigen Ansprüche, **dadurch gekennzeichnet, daß** die A-posteriori-Verteilungsfunktion auf den Summensignalwert von eins normiert wird.

14. Verfahren zur Fehlerverdeckung nach einem der vorherigen Ansprüche, **dadurch gekennzeichnet, daß** die die Empfangsqualität berücksichtigende Verteilungsfunktion gleichverteilt ist.

**15.** Verfahren zur Fehlerverdeckung nach einem der vorherigen Ansprüche,
**dadurch gekennzeichnet, daß** der benutzte Parameterschätzer auf die Minimierung des quadratischen Fehlers zielt.

**16.** Vorrichtung zur Fehlerverdeckung und Verbesserung der Signalqualität in digitalen Übertragungssystemen zur Übertragung von Sprach-, Audio-, Bildund/oder Videosignalen, in denen empfangsseitig eine Verteilungsfunktion zur Schätzung übertragener Parameter bestimmt wird,
**dadurch gekennzeichnet, daß** ein Mittel vorhanden ist, das geeignet ist, eine gegebene, A-priori-Verteilungsfunktion, die direkt oder indirekt das Histogramm eines Prädiktionsfehlersignals (e(k)) repräsentiert, um den quantisierten (3) Ausgangssignalwert eines Prädiktors (2), der eine Prädiktion des zu schätzenden Parameterwertes (v(k)) durchführt, zu verschieben (4) und abschnittsweise zu einer neuen Verteilungsfunktion (pp(i,k)) aufzuintegrieren (6), und diese neue Verteilungsfunktion (pp(i,k)) mit einer die Empfangsqualität berücksichtigenden Verteilungsfunktion (pc(i,k)) zu multiplizieren, mit dem Ergebnis einer A-posteriori-Verteilung (p(i,k)), die in konventionellen Schätzverfahren zur letztendlichen Parameterschätzung verwendet wird, dass das Mittel einen Verschiebeblock (4) beinhaltet, um ein gegebenes vektorielles Signal $pa(l,k)$ um eine Anzahl von $L \cdot 2^M$-$j(k)$ Vektordimensionen, d.h.

$$pv(m,k) = pa(m = l - [L \cdot 2^M - j(k)],k),$$

zu verschieben;
dabei bezeichnet $l$ einen Zähler über alle Vektordimensionen in $pa(l,k)$ mit $0 \le l \le L \cdot 2^{M+1}-1$, und $m$ ist ein verschobener Zähler über den eingeschränkten Bereich $0 \le m \le L \cdot 2^M - 1$,
dass das Mittel einen Quantisieres (3) und einen Summierer (6) beinhaltet, und dass der Summierer (6) geeignet ist, das vektorielle Signal $pv(m,k)$ der Vektordimension $L \cdot 2^M$ abschnittweise aufzusummieren, so daß sich ein vektorielles Signal $pp(i, k)$ mit $0 \le i \le 2^M - 1$ ergibt:

$$pp(i,k) = \sum_{m=ui}^{oi} pv(m,k) \;\; ;$$

dabei bezeichnen $ui$ bzw. $oi$ den untersten bzw. den obersten Quantisierungstabellenindex des Quantisierers (3).

**17.** Vorrichtung nach Anspruch 16, **dadurch gekennzeichnet, daß** das Mittel eine Reihenschaltung aus einem Prädiktor (2), einem Quantisierer (3), einem Verschiebeblock (4), einem Summierer (6) und einem Multiplizierer (7) beinhaltet.

**18.** Vorrichtung nach Anspruch 16, **dadurch gekennzeichnet, daß** das Mittel einen Prozessor geeigneter Programmierung beinhaltet.

**19.** Vorrichtung nach Anspruch 16, **dadurch gekennzeichnet, daß** es sich anstelle um einen Parameter um eine durch eine beliebige umkehrbare Funktion (v'(k)) aus einem Parameter hervorgegangene Größe handelt.

**Claims**

**1.** Process for error concealment and improving signal quality in digital transmission systems for transmitting speech, audio, picture and/or video signals, in which a distribution function for estimating transmitted parameters is determined on the receiving side, **characterised in that** a given, a *priori* distribution function, directly or indirectly representing the histogram of a prediction error signal (e(k)), is relocated (4) by the quantized (3) output signal value of a predictor (2), which carries out a prediction of the parameter value (v(k)) to be estimated, and is integrated (6) in sections into a new distribution function (pp(i,k)), this new distribution function (pp(i,k)) is multiplied by a distribution function (pc(i,k)), which takes into account the receiving quality, with the result of an a *posteriori* distribution (p(i,k)), which is used in conventional estimation processes for ultimate parameter estimation, **in that** by means of a relocation block (4) a given vectorial signal $pa(l,k)$ is relocated by a number of $L \cdot 2^M$-j(k) vector dimen-

sions, i.e.

$$pv(m,k) = pa(m = 1- [L \cdot 2^M -j(k)],k;$$

1 therein denotes a counter over all vector dimensions in $pa(l,k)$ with $0 \leq 1 \leq L \cdot 2^{M+1} -1$, and $m$ is a relocated counter over the restricted range $0 \leq m \leq L \cdot 2^M -1$, and
the vectorial signal $pv(m,k)$ of the vector dimension $L \cdot 2^M$ is summed up in sections by a summer (6), so a vectorial signal $pp(i,k)$ with $0 \leq i \leq 2^M -1$ results:

$$pp(i,k) = \sum_{m=ui}^{oi} pv(m,k);$$

$ui$ and $oi$ therein denote the lowest and the highest quantizing table index of a quantizer (3).

**2.** Process for error concealment according to claim 1, **characterised in that** earlier, estimated parameters form the input signal of the predictor.

**3.** Process for error concealment according to claim 1 or 2, **characterised in that** the received parameters or a mixed variable of earlier, estimated parameters and the received parameters form the input signal of the predictor.

**4.** Process for error concealment according to one of the preceding claims, **characterised in that** the predictor operates with one or more fixed sets of coefficients.

**5.** Process for error concealment according to one of claims 1 to 3, **characterised in that** the predictor operates with adaptively tracked sets of coefficients.

**6.** Process according to claim 1, **characterised in that**, instead of a parameter, a variable produced from a parameter by any reversible function (v'(k)) is involved.

**7.** Process for error concealment according to one of the preceding claims, **characterised in that** the distribution functions are present as discrete and integration changes into a summation.

**8.** Process for error concealment according to one of the preceding claims, **characterised in that** a distribution function to be relocated is kept stored in the receiver.

**9.** Process for error concealment according to one of claims 1 to 7, **characterised in that** several distribution functions are stored in the receiver and those to be relocated are selected according to suitable criteria.

**10.** Process for error concealment according to one of claims 1 to 7, **characterised in that** one or more distribution functions are stored in the receiver, one is selected according to suitable criteria and the distribution function to be relocated is formed by selection of suitable signal values of the selected distribution function.

**11.** Process for error concealment according to one of the preceding claims, **characterised in that** the distribution function to be relocated is wholly or partially calculated.

**12.** Process for error concealment according to one of the preceding claims, **characterised in that** the relocation of the distribution function is realised by suitable addressing.

**13.** Process for error concealment according to one of the preceding claims, **characterised in that** the a *posteriori* distribution function is scaled to the sum signal value of one.

**14.** Process for error concealment according to one of the preceding claims, **characterised in that** the distribution function taking account of the receiving quality is equally distributed.

**15.** Process for error concealment according to one of the preceding claims, **characterised in that** the parameter estimator used aims at minimising the quadratic error.

**16.** Device for error concealment and improving signal quality in digital transmission systems for transmitting speech, audio, picture and/or video signals, in which a distribution function for estimating transmitted parameters is determined on the receiving side, **characterised in that** there is a means which is suitable for relocating (4) a given, *a priori* distribution function, directly or indirectly representing the histogram of a prediction error signal (e(k)), by the quantized (3) output signal value of a predictor (2), which carries out a prediction of the parameter value (v(k)) to be estimated, and for integrating it (6) in sections into a new distribution function (pp(i,k')) and to multiply this new distribution function (pp(i,k)) by a distribution function (pc(i,k)), which takes into account the receiving quality, with the result of an a *posteriori* distribution (p(i,k)), which is used in conventional estimation processes for ultimate parameter estimation, **in that** the means contains a relocation block (4), in order to relocate a given vectorial signal *pa(l,k)* by a number of $L \cdot 2^M$-j(k) vector dimensions, i.e.

$$pv(m,k) = pa(m = 1- [L \cdot 2^M \text{-}j(k)],k);$$

l therein denotes a counter over all vector dimensions in *pa(l,k)* with $0 \leq 1 \leq L \cdot 2^{M+1}$ -1, and *m* is a relocated counter over the restricted range $0 \leq m \leq L \cdot 2^M$ -1, **in that** the means contains a quantizer (3) and a summer (6) and the summer (6) is suitable for summing up the vectorial signal *pv(m,k)* of the vector dimension $L \cdot 2^M$ in sections, so a vectorial signal *pp(i,k)* with $0 \leq i \leq 2^M$ -1 results:

$$pp(i,k) \;=\; \sum_{m=ui}^{oi} pv(m,k);$$

*ui* and *oi* therein denote the lowest and the highest quantizing table index of the quantizer (3).

**17.** Device according to claim 16, **characterised in that** the means has a series circuit consisting of a predictor (2), a quantizer (3), a relocation block (4), a summer (6) and a multiplier (7).

**18.** Device according to claim 16, **characterised in that** the means contains a processor with suitable programming.

**19.** Device according to claim 16, **characterised in that**, instead of a parameter, a variable produced from a parameter by any reversible function (v'(k)) is involved.

**Revendications**

**1.** Procédé pour masquer les erreurs et améliorer la qualité de signal dans des systèmes de transmission numériques pour la transmission de signaux vocaux, audio, d'image et/ou vidéo, dans lesquels côté réception, on détermine une fonction de distribution pour l'évaluation de paramètres transmis,
**caractérisé en ce qu'**une fonction de distribution à priori, donnée, qui représente directement ou indirectement l'histogramme d'un signal d'erreur de prédiction (e(k)), est décalée (4) de la valeur du signal de sortie quantifiée (3) d'un élément de prédiction (2), qui effectue une prédiction de la valeur du paramètre à évaluer (v(k)), et est intégrée (6) par tronçons en une nouvelle fonction de distribution (pp(i,k)), cette nouvelle fonction de distribution (pp(i,k)) est multipliée par une fonction de distribution (pc(i,k)) tenant compte de la qualité de réception, avec pour résultat une distribution à posteriori (p(i,k)), qui est utilisée dans des procédés d'évaluation conventionnels pour l'évaluation finale des paramètres,
**en ce qu'**au moyen d'un bloc de décalage (4), un signal vectoriel donné pa(l,k) est décalé d'un nombre de $L \cdot 2^M$ - j(k) dimensions de vecteur, c'est à dire

$$pv(m,k) = pa(m=l-[L \cdot 2^M - j(k)], k)$$

l désignant un compteur sur toutes les dimensions de vecteur en pa(l,k) avec $0 \leq l \leq L \cdot 2^{M+1}$ - 1, et m est un compteur décalé sur la plage limitée $0 \leq m \leq L \cdot 2^M - 1$,

et **en ce que** le signal vectoriel pv(m,k) de la dimension de vecteur $L \cdot 2^M$ est sommé par tronçons au moyen d'un élément de sommation (6), de sorte qu'il en résulte un signal vectoriel pp(i,k) avec $0 \leq i \leq 2^M - 1$ :

$$pp(i,k) = \sum_{m=ui}^{oi} pv(m,k) \quad,$$

avec ui et respectivement oi désignant l'index inférieur et respectivement supérieur de tableau de quantification d'un quantificateur (3).

2.  Procédé pour masquer les erreurs selon la revendication 1, **caractérisé en ce que** des paramètres évalués antérieurs forment le signal d'entrée de l'élément de prédiction.

3.  Procédé pour masquer les erreurs selon la revendication 1 ou 2, **caractérisé en ce que** les paramètres reçus ou une grandeur de mélange de paramètres évalués antérieurs et des paramètres reçus forment le signal d'entrée de l'élément de prédiction.

4.  Procédé pour masquer les erreurs selon l'une des revendications précédentes, **caractérisé en ce que** l'élément de prédiction travaille avec un ou plusieurs jeux de coefficients fixes.

5.  Procédé pour masquer les erreurs selon l'une des revendications1 à 3, **caractérisé en ce que** l'élément de prédiction travaille avec des jeux de coefficients s'ajustant de manière adaptative.

6.  Procédé pour masquer les erreurs selon la revendication 1, **caractérisé en ce qu'**à la place d'un paramètre, il s'agit d'une grandeur résultant d'un paramètre par une fonction inversible quelconque (v'(k)).

7.  Procédé pour masquer les erreurs selon l'une des revendications précédentes, **caractérisé en ce que** les fonctions de distribution se présentent sous forme discrétisée et l'intégration se transforme en sommation.

8.  Procédé pour masquer les erreurs selon l'une des revendications précédentes, **caractérisé en ce que** l'on dispose d'une fonction de distribution à décaler, qui est mémorisée dans le récepteur.

9.  Procédé pour masquer les erreurs selon l'une des revendications 1 à 7, **caractérisé en ce que** l'on dispose de plusieurs fonctions de distribution mémorisées dans le récepteur, et l'on sélectionne celle à décaler, selon des critères appropriés.

10. Procédé pour masquer les erreurs selon l'une des revendications 1 à 7, **caractérisé en ce que** l'on dispose d'une ou de plusieurs fonctions de distribution mémorisées dans le récepteur, **en ce que** l'une d'entre-elles est sélectionnée selon des critères appropriés, et **en ce que** l'on forme la fonction de distribution à décaler par la sélection de valeurs de signal appropriées de la fonction de distribution sélectionnée.

11. Procédé pour masquer les erreurs selon l'une des revendications précédentes, **caractérisé en ce que** la fonction de distribution à décaler est entièrement ou partiellement calculée.

12. Procédé pour masquer les erreurs selon l'une des revendications précédentes, **caractérisé en ce que** le décalage de la fonction de distribution se fait par un adressage approprié.

13. Procédé pour masquer les erreurs selon l'une des revendications précédentes, **caractérisé en ce que** la fonction de distribution à posteriori est normée à une valeur du signal de sommation égale à un.

14. Procédé pour masquer les erreurs selon l'une des revendications précédentes, **caractérisé en ce que** la fonction de distribution tenant compte de la qualité de réception est d'une distribution uniforme.

15. Procédé pour masquer les erreurs selon l'une des revendications précédentes, **caractérisé en ce que** l'élément d'évaluation de paramètre utilisé vise la minimisation du carré de l'erreur.

**16.** Dispositif pour masquer les erreurs et améliorer la qualité de signal dans des systèmes de transmission numériques pour la transmission de signaux vocaux, audio, d'image et/ou vidéo, dans lesquels côté réception, est déterminée une fonction de distribution pour l'évaluation de paramètres transmis,
**caractérisé en ce qu'**il comporte un moyen adapté à décaler une fonction de distribution à priori, donnée, qui représente directement ou indirectement l'histogramme d'un signal d'erreur de prédiction ($e(k)$), de la valeur du signal de sortie quantifiée (3) d'un élément de prédiction (2), qui effectue une prédiction de la valeur du paramètre à évaluer ($v(k)$), et à l'intégrer (6) par tronçons en une nouvelle fonction de distribution ($pp(i,k)$), et à multiplier cette nouvelle fonction de distribution ($pp(i,k)$) par une fonction de distribution ($pc(i,k)$) tenant compte de la qualité de réception, avec pour résultat une distribution à posteriori ($p(i,k)$), qui est utilisée dans des procédés d'évaluation conventionnels pour l'évaluation finale des paramètres,
**en ce que** ledit moyen englobe un bloc de décalage (4), en vue de décaler un signal vectoriel donné $pa(l,k)$, d'un nombre de $L \cdot 2^M - j(k)$ dimensions de vecteur, c'est à dire

$$pv(m,k) = pa(m=I-[L \cdot 2^M - j(k)], k)$$

l désignant un compteur sur toutes les dimensions de vecteur en $pa(l,k)$ avec $0 \leq I \leq L \cdot 2^{M+1} - 1$, et m est un compteur décalé sur la plage limitée $0 \leq m \leq L \cdot 2^M - 1$,
**en ce que** ledit moyen englobe un quantificateur (3) et un élément de sommation (6),
et **en ce que** l'élément de sommation (6) est adapté à effectuer la sommation par tronçons du signal vectoriel $pv(m,k)$ de la dimension de vecteur $L \cdot 2^M$, de sorte qu'il en résulte un signal vectoriel $pp(i,k)$ avec $0 \leq i \leq 2^M - 1$ :

$$pp(i,k) = \sum_{m=ui}^{oi} pv(m,k) \quad ,$$

avec ui et respectivement oi désignant l'index inférieur et respectivement supérieur de tableau de quantification du quantificateur (3).

**17.** Dispositif selon la revendication 16, **caractérisé en ce que** ledit moyen englobe un circuit série constitué d'un élément de prédiction (2), d'un quantificateur (3), d'un bloc de décalage (4), d'un élément de sommation (6) et d'un élément mutiplicateur (7).

**18.** Dispositif selon la revendication 16, **caractérisé en ce que** ledit moyen englobe un processeur à programmation appropriée.

**19.** Dispositif selon la revendication 16, **caractérisé en ce qu'**à la place d'un paramètre, il s'agit d'une grandeur résultant d'un paramètre par une fonction inversible quelconque ($v'(k)$).

Fig. 1

Fig. 2